# EUROPÄISCHE PATENTANMELDUNG

(11) **EP 2 017 858 A2**
(43) Veröffentlichungstag der Anmeldung: **21.01.2009**
(21) Anmeldenummer: 08009691.0
(22) Anmeldetag: 28.05.2008
(51) Int. Cl.: H01F 1/37, C09D 11/00

(54) **Paste zur Herstellung einer Induktivität**

(30) Priorität: 11.06.2007 DE 102007028089
(71) Anmelder: Würth Elektronik Pforzheim GmbH & Co. KG, 75175 Pforzheim (DE)
(72) Erfinder: Dietrich, Frank, 73760 Ostfildern (DE)
(74) Vertreter: Patentanwälte Ruff, Wilhelm, Beier, Dauster & Partner

(57) **Zusammenfassung**

Die Erfindung schlägt eine Paste vor, die in einem Bindemittel elektrisch nicht leitendes Ferritpulver als Pigment enthält, sowie fein verteiltes leitendes Material, insbesondere Silber oder Kupfer. Diese Paste kann in einem Siebdruckverfahren auf eine Leiterplatte aufgedruckt werden. Auf diese Weise lassen sich Induktivitäten auf Leiterplatten in einem einfachen einstufigen Verfahren herstellen. Das elektrisch leitende Material kann entweder ebenfalls als Pigment in dem Bindemittel verteilt sein oder als Beschichtung des Ferritpulvers. Durch Auswahl des elektrisch leitenden Materials, der Menge dieses Materials und dem Verhältnis zwischen elektrisch leitendem Material und Ferritpulver lassen sich die elektrischen und/oder magnetischen Eigenschaften der auf diese Weise hergestellten Induktivität einstellen.

## Beschreibung

Die Erfindung betrifft die Herstellung von Induktivitäten auf Leiterplatten.

In der Elektronik werden Induktivitäten zu den unterschiedlichsten Zwecken benötigt. Sie werden als Spulen mit einem Kern aus weichmagnetischem Material realisiert. Als weichmagnetisches Material wird üblicherweise Ferrit verwendet. Für die Spule selbst kann sowohl eine aus Draht gewickelte Spule als auch eine entsprechend ausgeführte gedruckte Leiterplatte verwendet werden. Häufig werden diese Induktivitäten als getrennte Bauteile hergestellt, die dann mit der Leiterplatte verbunden werden, beispielsweise in SMT-Technik. Beispiele für die Verwendung von Induktivitäten sind Filter, die Entstörung der Signalleitungen für die Computer, Speicherspulen und induktive Näherungsschalter.

Die Verwendung zweier verschiedener Materialien, nämlich der Leiter für die Spulenwindungen und der Ferrite für die Kerne, bedeutet einen erhöhten Herstellungsaufwand.

Andere passive Komponenten, die in elektronischen Schaltungen verwendet werden, wie Widerstände und Kapazitäten, können im Unterschied zu Induktivitäten im Siebdruck realisiert werden.

Der Erfindung liegt die Aufgabe zu Grunde, eine Möglichkeit der vereinfachten und verbesserten Herstellung von Induktivitäten zu schaffen.

Zur Lösung dieser Aufgabe schlägt die Erfindung eine Paste mit den im Anspruch 1 genannten Merkmalen, die Verwendung dieser Paste zur Herstellung von Induktivitäten und eine daraus hergestellte Induktivität vor. Weiterbildungen der Erfindung sind Gegenstand der jeweiligen abhängigen Patentansprüche.

Die Paste enthält also, in einem Bindemittel gebunden, Ferritpulver als Pigment. Zusätzlich enthält die Paste leitendes Material in fein verteilter Form. Die Paste ist also ähnlich aufgebaut wie sonstige Pasten, die in der Elektronik zur Herstellung von Schaltungen auf Leiterplatten verwendet werden, und die mit den üblichen Verfahren verarbeitet werden können. Beispiele derartiger Pasten sind Lotpaste, Pasten zum Aufdrucken von Widerständen und so weiter.

Die Paste verwendet also die Leitfähigkeit des leitenden Materials und die Induktivität des Ferritmaterials.

Als Bindemittel zum Binden des Ferritpulvers und des elektrisch leitenden Materials kommt in Weiterbildung der Erfindung insbesondere Harz infrage.

Als leitendes Material ist in Weiterbildung der Erfindung Kupfer vorgesehen, oder auch Silber. Beide Materialien haben eine hohe elektrische Leitfähigkeit und eignen sich daher besonders für die Darstellung der Induktivitäten.

In Weiterbildung der Erfindung kann vorgesehen sein, dass das leitende Material ähnlich wie das Ferritpulver als Pigment vorhanden ist. Damit ist dann das Ferritpulver mit dem leitfähigen Pigment vermischt. Beim Aufbringen dieser Paste entsteht eine Matrix aus Ferriten und leitfähigen Pigmenten, die vorzugsweise kolloidal ausgebildet ist.

Eine weitere von der Erfindung vorgeschlagene Möglichkeit besteht darin, dass das Ferritpulver beschichtet ist, so dass das mit dem leitenden Material beschichtete Ferritpulver als Pigment in der vorzugsweise harzgebundenen Paste angeordnet ist. Beim Aufbringen der Paste auf eine Leiterplatte entsteht also eine Matrix aus beschichteten Ferriten, vorzugsweise sphärisch.

Erfindungsgemäß kann in Weiterbildung vorgesehen sein, dass die Beschichtung und/oder das als Pigment vorliegende leitende Material so imprägniert ist, dass es mit dem Bindemittel so zusammenarbeiten kann, dass das leitfähige Material nicht korrodiert und damit seine Leitfähigkeit verliert.

Eine Paste mit den beschriebenen Eigenschaften kann dann in einem der bekannten Verfahren, beispielsweise Siebdruck, Aufsprühen, oder Eintauchen der Leiterplatte oder eines Teils der Leiterplatte in die Paste, auf der Leiterplatte aufgebracht werden. Auch andere kontrollierte Beschichtungsverfahren sind möglich. Durch Auswahl der Menge sowohl des Ferritpulvers als auch des leitenden Materials, durch Auswahl des Verhältnisses von leitendem Material zu Ferritmaterial, durch Auswahl des Bindemittels stehen ausreichend Parameter zur Verfügung, um die leitenden und magnetischen Eigenschaften der Paste auf den speziellen Anwendungsfall ausrichten zu können.

Weitere Merkmale, Einzelheiten und Vorzüge der Erfindung ergeben sich aus den Ansprüchen und der Zusammenfassung, deren beider Wortlaut durch Bezugnahme zum Inhalt der Beschreibung gemacht wird, der folgenden Beschreibung bevorzugter Ausführungsformen der Erfindung sowie anhand der Zeichnung. Hierbei zeigen:
- Figur 1: einen Ausschnitt aus einer auf einer Leiterplatte aufgedruckten Paste zu Darstellung einer Induktivität;
- Figur 2: eine der Figur 1 entsprechende Darstellung bei einer geänderten Ausführungsform.

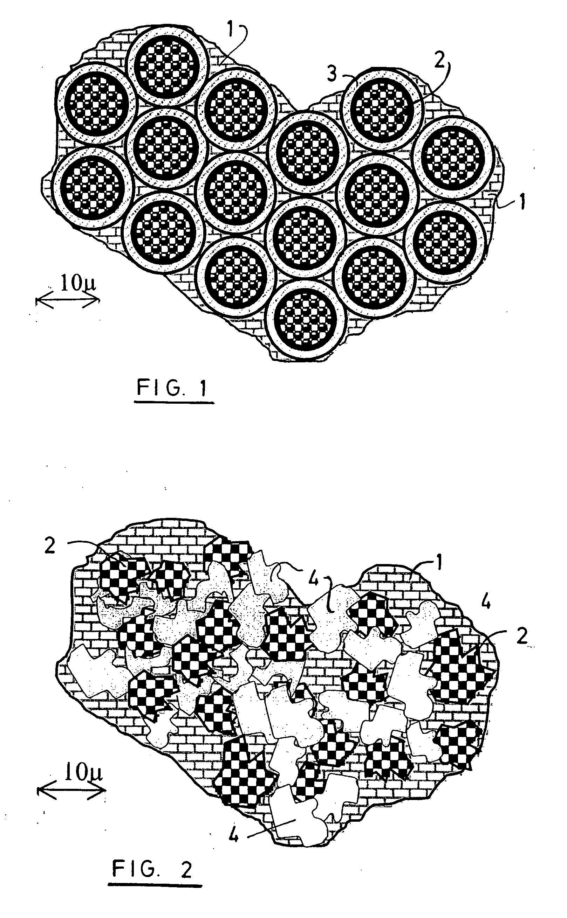

Figur 1 zeigt schematisch einen Ausschnitt aus einer auf eine Leiterplatte aufgebrachten Schicht aus einer Paste. Diese Schicht enthält in einer Harzmatrix 1 eine Vielzahl von angenähert kugelförmigen Ferritteilen 2 aus Ferritpulver, die von einer Schicht aus leitfähigem Material umgeben sind. Bei dieser kugelschalenförmigen Beschichtung 3 handelt es sich um eine Beschichtung beispielsweise aus Silber. Die dadurch gebildeten Pigmente, nämlich Ferritpulver 2 beschichtet mit Silber 3, liegen in der Harzmatrix 1 eingebettet und berühren sich. Dadurch wird ein Strompfad ermöglicht, der zusammen mit dem Ferritpulver aus nicht leitendem Material dann eine Induktivität darstellen kann.

Figur 2 zeigt einen ähnlichen Ausschnitt einer geänderten Ausführungsform, bei der in der Harzmatrix 1 Ferritpulver 2 als Pigment und leitendes Material 4 ebenfalls als Pigment angeordnet sind. Auch hier bildet sich durch das leitfähige Material 4 ein Strompfad, der zusammen mit dem Ferritpulver 2 eine Induktivität bilden kann.

Die Größenverhältnisse sind durch das links eingezeichnete Größenmaß dargestellt.

## Patentansprüche

1. Paste zur Herstellung von Induktivitäten, enthaltend
1.1 Pigment aus Ferritpulver (2),
1.2 Bindemittel (1) zum Binden des Pigments und
1.3 elektrisch leitendes Material (3, 4).

2. Paste nach Anspruch 1, bei der das Bindemittel (1) zum Binden des Pigments Harz ist.

3. Paste nach Anspruch 1 oder 2, bei der das leitende Material (3, 4) Kupfer ist beziehungsweise enthält.

4. Paste nach einem der vorhergehenden Ansprüche, bei der das leitende Material (3, 4) Silber enthält beziehungsweise ist.

5. Paste nach einem der vorhergehenden Ansprüche, bei der das leitende Material (3, 4) als Pigment vorhanden ist.

6. Paste nach einem der vorhergehenden Ansprüche, bei der das leitende Material (3, 4) als Beschichtung des Ferritpulvers (2) vorhanden ist.

7. Paste nach einem der vorhergehenden Ansprüche, bei der das leitende Material (3, 4) derart imprägniert ist, dass es in dem Bindemittel nicht korrodiert.

8. Verfahren zum Herstellen einer Induktivität auf einer Leiterplatte, bei dem eine Paste nach einem der vorhergehenden Ansprüche auf die Leiterplatte aufgebracht wird.

9. Verfahren nach Anspruch 8, bei dem die Paste aufgedruckt wird, insbesondere in einem Siebdruckverfahren.

10. Verfahren nach Anspruch 8, bei dem die Paste aufgesprüht wird.

11. Verfahren nach Anspruch 8, bei dem die Paste durch Eintauchen der Leiterplatte aufgebracht wird.

12. Verfahren nach einem der Ansprüche 8 bis 11, bei dem die magnetischen und/oder elektrischen Eigenschaften der Induktivität durch Auswahl des Materials und des Verhältnisses von leitendem Material zu dem Ferritpulver (2) eingestellt werden.

13. Induktivitätsbauteil, das durch Aufbringen einer Paste nach einem der Ansprüche 1 bis 7 auf einer Leiterplatte herstellbar ist.

14. Induktivitätsbauteil nach Anspruch 13, bei dem die Paste im Siebdruckverfahren aufgedruckt ist.

15. Induktivitätsbauteil nach Anspruch 13 oder 14, bei dem die Paste durch Aufsprühen aufgebracht ist.

16. Induktivitätsbauteil nach Anspruch 13, bei dem die Paste durch Eintauchen der Leiterplatte aufgebracht ist.

17. Verwendung einer Paste nach einem der Ansprüche 1 bis 7 zur Herstellung einer Induktivität durch Aufbringen der Paste auf einer Leiterplatte.
